# EUROPEAN PATENT SPECIFICATION

(11) **EP 3 076 414 B1**
(45) Date of publication and mention of the grant of the patent: **01.08.2018**
(21) Application number: 16157755.6
(22) Date of filing: 26.02.2016
(51) Int. Cl.: H01F 41/04, H01F 27/28, H01F 17/00, H01F 5/00, H01F 19/04, H01L 23/522, H01L 49/02

(54) **TUNING INDUCTANCE RATIO OF A PASSIVE DEVICE**
ABSTIMMUNG DES INDUKTIVITÄTSVERHÄLTNISSES EINER PASSIVEN VORRICHTUNG
RAPPORT D'INDUCTANCE D'ACCORD D'UN DISPOSITIF PASSIF

(30) Priority: 28.03.2015 US 201514672162
(43) Date of publication of application: 05.10.2016
(73) Proprietor: Intel IP Corporation, Santa Clara, CA 95054 (US)
(72) Inventor: MARUTHAMUTU, Saravana, 82008 München (DE)
(74) Representative: Rummler, Felix

(56) References cited:
- EP-A2- 0 324 240
- US-A1- 2013 009 704
- US-A1- 2013 140 672

## Description

### BACKGROUND

### Field

Integrated circuit devices.

### Description of Related Art

Passive inductive elements like transformers and coils generally do not scale with downscaling integrated circuit (IC) technologies. In Radio Frequency (RF) complementary metal oxide semiconductor (CMOS) cellular and connectivity transceivers transformers are key elements for impedance matching applications. Transformer layout designs can easily occupy area above one square millimeter for meeting a specified frequency and inductance ratio.

Low cost CMOS processes generally have two top generally thick metal levels that are usable for inductor and transformer devices. Coils in packages with two level metal redistribution layers may also be exploited for inductor and transformer applications.

Transformer design generally requires a high coupling co-efficient (k) between a primary winding and a secondary winding for maximum energy transfer. A coupling factor, k, can have values between 0 (no coupling) and 1 (high coupling). There are generally two types of transformers that are suitable in silicon chip or package technologies for a high coupling factor, a vertically coupled transformer and a laterally coupled transformer in two adjacent metal layers (e.g., the ultimate and penultimate metal layers of a chip). The design rules of the technologies, area of the transformer, distance of separation between metals (e.g., between a top metal 1 and a top metal 2) and the conductivity of the metals often favors the design of laterally coupled transformers for high coupling (coupling factor greater than 0.7) on chip or on package.

An issue in a two metal laterally coupled transformer is tuning to the required inductance ratio between the primary and the secondary windings. For example, it is not so easy to get inductance ratios above 3:1 with a laterally coupled transformer. EP0324240 discloses a planar transformer with a shunt between the innermost of the primary and secondary windings.

### BRIEF DESCRIPTION OF THE DRAWINGS

Figure 1 shows an embodiment of a transformer of an impedance matching transformer device that is representatively formed in adjacent metal layers of a chip on a package.
Figure 2 illustrates the inductance differential of the transformer of Figure 1 .
**Figure 3** shows another embodiment of a transformer device.
**Figure 4** illustrates the inductance differential of the device of **Figure 3****.**
**Figure 5** illustrates an embodiment of a computing device.

### DETAILED DESCRIPTION

An apparatus is described that includes a passive device such as a transformer on a chip or package including a primary winding and a secondary winding interwound and magnetically connected in two metal layers. An inductance of one of the primary winding and the secondary winding is tuned for a target inductance ratio between the primary winding and the secondary winding. Methods of constructing device layouts in two level metal stacks to tune an inductance of the one of a primary winding and a secondary winding for a target primary to secondary inductance ratio is also described. The apparatus is specified by claim 1, the respective method by claim 9.

In one embodiment, a device is a passive device that is a transformer. In one representative example, a radio frequency (RF) transceiver circuit requires an impedance matching transformer with a primary inductance on the order of 2.5 nanohenries (nH) and a secondary inductance on the order of 0.7 nH with a high coupling co-efficient (e.g., greater than 0.7) at an operating frequency of 2 gigahertz (GHz). The following transformer device layouts illustrate devices tuned to meet this representative example.

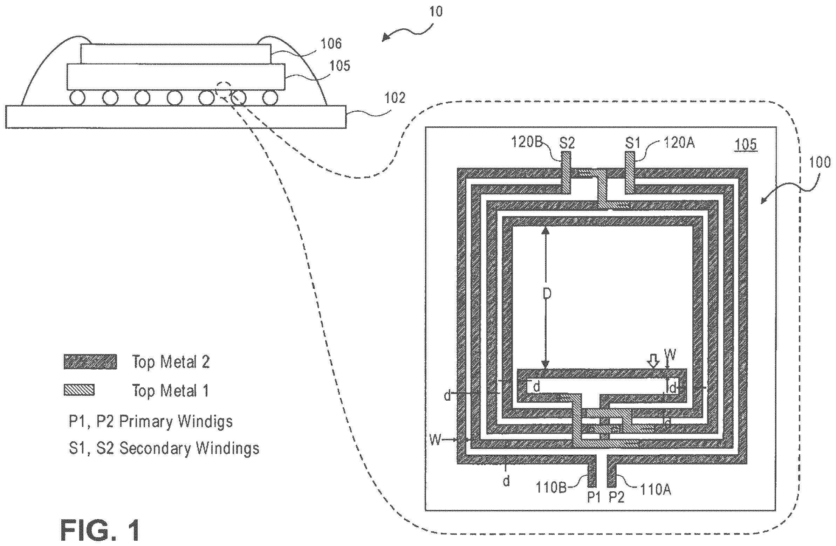

**Figure 1** shows an embodiment of a transformer of an impedance matching transformer device for a RF transceiver circuit that is representatively formed in adjacent metal layers of a which does not belong to the invention. **Figure 1** shows a side view of a portion of a package including package substrate 102 to which chip 105 is connected. Chip 105 is, for example, an RF baseband die. Also connected to package substrate 102 is secondary chip 106 such as a memory chip. In the illustrated embodiment, chip 105 and secondary chip 106 are arranged in a stacked arrangement. In another embodiment, the chips may be assembled in package 10 in a side-by-side arrangement. **Figure 1** also shows a magnified top view of a portion of a device side of chip 105 that includes transformer device 100. In this embodiment, transformer device 100 includes primary winding 110A and primary winding 110B and secondary winding 120A and secondary winding 120B. The primary windings and secondary windings are interwound and magnetically coupled in two metal layers of a chip or package in a laterally coupled layout. The windings are interwound into a quadrilateral spiral (e.g., square or rectangular spirals) with each winding having a width, w, of the conductive metal layer and a spacing between adjacent winding. In one embodiment, the windings are formed of a conductive material such as a copper material by conventional techniques such as patterning and deposition (e.g., seeding and electroplating) techniques in, for example, the top two metal layers of a chip or a package. Each winding includes, in one aspect, a perimeter dimension defined by a spacing between the winding and an adjacent outer winding (as viewed). For all but the innermost winding, the spacing, d, between the winding an adjacent outer winding is the same or approximately the same on each of four sides of the quadrilateral spiral. As illustrated in this embodiment, the innermost winding (a secondary winding) includes a perimeter dimension defined by spacing between such winding and an adjacent outer winding wherein the spacing, D, on one side is different than the spacing, d, on the other sides of the winding. The spacing, D, on one side of the winding is significantly greater than the spacing, d, on the three other sides. Thus, the innermost winding of transformer device 100 is reduced (scaled smaller) than the available area permissible for such scaling should the spacing be constant on all sides. In the illustrated embodiment, the spacing, D, on one side of the winding is relative to an upper or top side of an adjacent winding. In another embodiment, the spacing, D, may be relative to a bottom or lower side of an adjacent winding or relative to a left or right side of an adjacent winding.

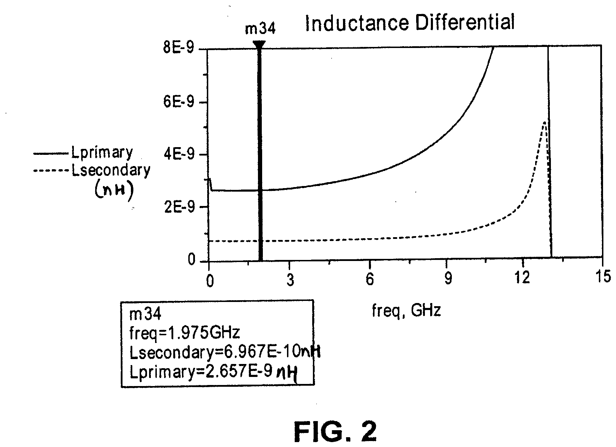

In one example, an area consumed by transformer device 100 is on the order of 239 x 239 µm². In one example, the transformer device has a frequency of 1.975 GHz; a secondary inductance (L_{secondary}=6.967E-10 nH); and a primary inductance (L_{primary}=2.647E-9 nH). Figure 2 illustrates the inductance differential. As can be seen, by reducing a perimeter of the interwinding (secondary winding), the inductance is scaled to match the target of a primary inductance around 2.5 nH; and second inductance on the order of 0.7 nH and an operating frequency of 2 GHz. For comparison, if the innermost winding had a perimeter dimension defined by a similar spacing on each of the four sides of the quadrilateral winding, an area of the transformer device would be similar (239 x 239 µm²); the frequency would be 2.037 GHz; the secondary inductance would be 1.078E-9 nH; and the primary inductance would be 2.645E-9 nH. In such case, a desired inductance ratio (L_{secondary}:L_{primary} on the order of 0.7:2.5) cannot be obtained as the secondary inductance is 1 nH.

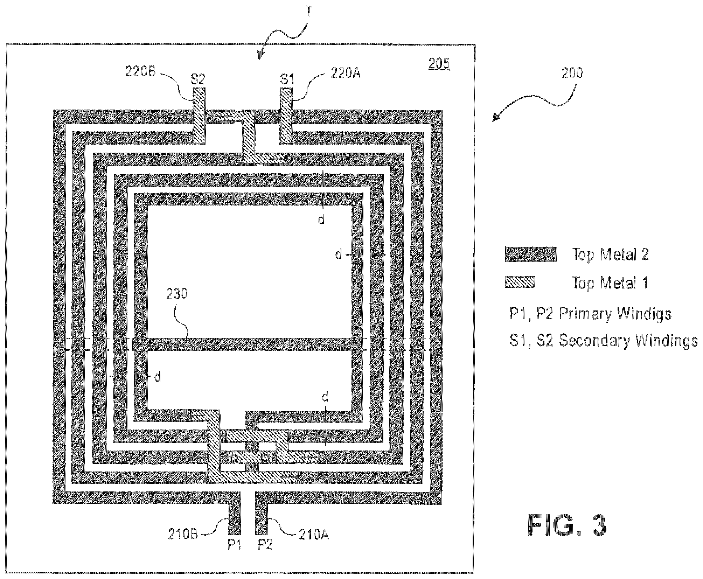

Figure 3 shows an embodiment of scaling of a winding of transformer device according to the invention. In this embodiment, there is no additional area increase in the scaled transformer device and there is flexibility in tuning the inductance of the secondary winding. Figure 3 shows device 200 formed in substrate 205 that is, for example, a chip or a package. In one embodiment, substrate 205 is a chip or die (e.g., RF baseband die) and is connected to a package substrate that also includes one or more memory chips. Similar to device 100, device 200 is, in one embodiment, an impedance matching transformer device including primary winding 210A and primary winding 210B and secondary winding 220A and secondary winding 220B interwound and magnetically coupled into metal layers of the substrate in a laterally coupled layout. The device is interwound into a quadrilateral spiral of the primary windings and secondary windings as known in the art with a top or upper side of the winding designated by the symbol, T. In this embodiment, each of the windings comprise a perimeter dimension defined by a spacing, d, between the winding and an adjacent outer winding, with the spacing, d, being the same on each side of each quadrilateral spiral. The spacing, d, on each side of a winding is illustrated with respect to the innermost winding and the winding outside the innermost winding. In this embodiment, the innermost winding is a secondary winding. In addition to the primary and secondary windings, device 200 includes shunt trace 230 of, for example, a conductive material. In one embodiment, shunt trace 230 is connected between two opposite sides of the innermost winding. By adding shunt trace 230, within the quadrilateral spiral, an additional inductance is introduced into the device without increasing an area of the device. Shunt trace 230, as illustrated, is in parallel to the innermost winding and is operable to reduce the inductance. Shunt trace 230 is, for example, a metal material similar to a metal material of the primary and secondary windings of device 200. Generally speaking, the greater the distance shunt trace 230 is from the top of the winding, T, the lower the secondary inductance. A configuration of shunt trace 230 is basically an inductance in parallel configuration of two inductors in parallel.

In one embodiment, shunt trace 230 has dimensions (width, thickness) similar to that of a winding. A shunt trace 230 of, for example, a copper material, may be introduced at the time of forming the innermost winding by conventional patterning and deposition (e.g., seeding followed by electroplating) techniques.

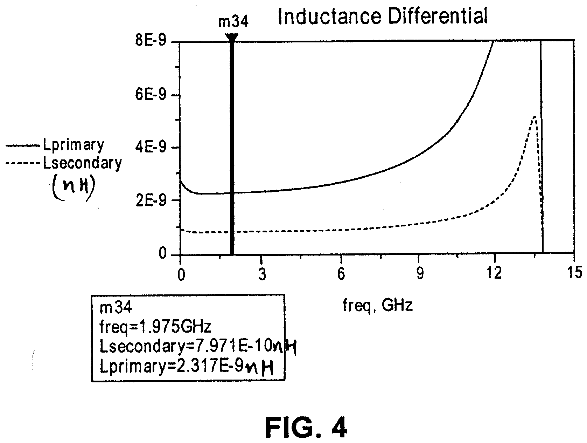

Figure 4 illustrates the inductance differential of the winding of device 200. The properties of the device are frequency of 1.975 GHz; a secondary inductance L_{secondary}= 7.971E-10 nH; and a primary inductance L_{primary}=2.317E-9 nH. As illustrated, the device complies with the objective of a primary inductance of around 2.2 nH and a secondary inductance of 0.8 nH with a coupling coefficient greater than 0.7 at an operating frequency of 2 GHz. Shunt trace 230 disposed between opposite side of the innermost winding to create an inductance in parallel to an innermost winding provides flexibility to tune the inductance. A positioning of the shunt line toward P1, P2 will tend to reduce the inductance. In an alternative embodiment, (illustrated in dashed lines in Figure 3), a shunting trace may be placed on the outermost winding rather than innermost winding.

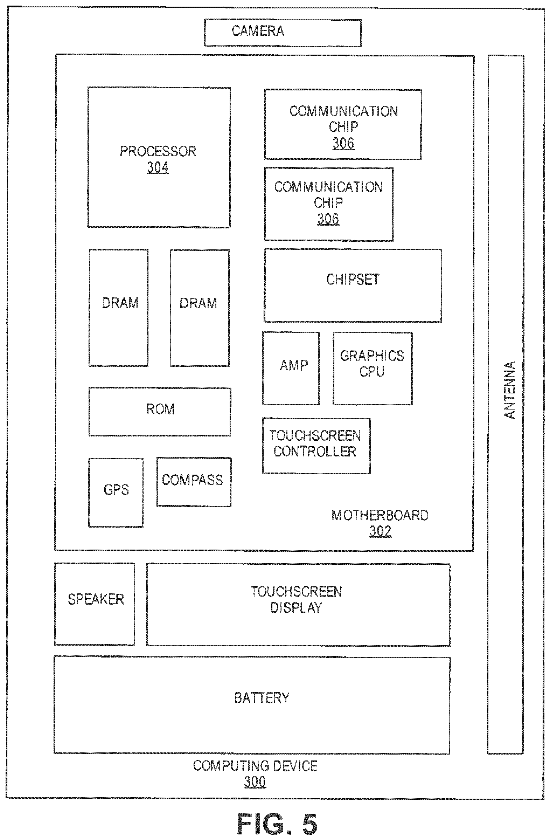

**Figure 5** illustrates computing device 300 in accordance with one implementation. Computing device 300 houses board 302. Board 302 may include a number of components, including but not limited to processor 304 and at least one communication chip 306. Processor 304 is physically and electrically coupled to board 302. In some implementations at least one communication chip 306 is also physically and electrically coupled to board 302. In further implementations, communication chip 306 is part of processor 304.

Depending on its applications, computing device 300 may include other components that may or may not be physically and electrically coupled to board 302. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

Communication chip 306 enables wireless communications for the transfer of data to and from computing device 300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 306 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Computing device 300 may include a plurality of communication chips 306. For instance, first communication chip 306 may be dedicated to shorter range wireless communications such as Wi-Fi and Bluetooth and second communication chip 306 may be dedicated to longer range wireless communications such as GPS, EDGE, GPRS, CDMA, WiMAX, LTE, Ev-DO, and others.

Processor 304 of computing device 300 includes an integrated circuit die packaged within processor 304. In some implementations, the integrated circuit die of the processor includes one or more devices, such as an impedance matched transformer formed in accordance with implementations described above. The term "processor" may refer to any device or portion of a device that processes electronic data from registers and/or memory to transform that electronic data into other electronic data that may be stored in registers and/or memory.

Communication chip 306 also includes an integrated circuit die packaged within communication chip 306. In accordance with another implementation, the integrated circuit die of the communication chip includes one or more devices, such as an impedance matched transformer formed in accordance with implementations described above.

In further implementations, another component housed within computing device 300 may contain an integrated circuit die that includes one or more devices, such as an impedance matched transformer formed in accordance with implementations described above.

In various implementations, computing device 300 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, computing device 300 may be any other electronic device that processes data.

### EXAMPLES

Example 1 is an apparatus including a device comprising a primary winding and a secondary winding interwound and magnetically coupled in two metal layers, wherein an inductance of one of the primary winding and the secondary winding is tuned for a target inductance ratio between the primary winding and the secondary winding. These features are part of the invention.

In Example 2, the device in the apparatus of Example 1 is interwound into a quadrilateral spiral of the primary winding and the secondary winding with an innermost winding of the transformer including a perimeter dimension defined by a spacing between the innermost winding and an adjacent winding being different on at least one side of the spiral.

In Example 3, the innermost winding in the apparatus of Example 2 includes a secondary winding.

In Example 4, the spacing between the innermost winding and an adjacent winding in the apparatus of Example 2 is greater on at least one side of the spiral than on the other sides of the spiral.

In Example 5, the spacing between the innermost winding and an adjacent winding in the apparatus of Example 4 is similar on the other sides of the spiral.

In Example 6, the device in the apparatus of Example 1 is interwound into a quadrilateral spiral of the primary winding and the secondary winding with each successive winding including a perimeter dimension defined by a spacing between the winding and an adjacent winding, the spacing being similar on each side of the spiral, and further including a shunt trace coupled between two opposite sides of a winding. The last feature is part of the invention.

In Example 7, the winding to which the shunt trace is coupled in the apparatus of Example 6 is an innermost winding. This feature is part of the invention.

In Example 8, the innermost winding in the apparatus of Example 7 includes a secondary winding. This feature is part of the invention.

Example 9 is an apparatus including a package including (1) a die including an impedance matching transformer device including a primary winding and a secondary winding interwound and magnetically coupled in two metal layers in a laterally coupled layout and an inductance of one of the primary winding and the secondary winding is tuned for a target inductance ratio between the primary winding and the secondary winding; and (2) a memory chip.

In Example 10, the transformer device in the apparatus of Example 9 is interwound into a quadrilateral spiral of the primary winding and the secondary winding with an innermost winding of the transformer including a perimeter dimension defined by a spacing between the innermost winding and an adjacent winding being different on at least one side of the spiral.

In Example 11, the innermost winding in the apparatus of Example 10 includes a secondary winding.

In Example 12, the spacing between the innermost winding and an adjacent winding in the apparatus of Example 10 is greater on at least one side of the spiral than on the other sides of the spiral.

In Example 13, the spacing between the innermost winding and an adjacent winding in the apparatus of Example 12 is similar on the other sides of the spiral.

In Example 14, the transformer device in the apparatus of Example 9 is interwound into a quadrilateral spiral of the primary winding and the secondary winding with each successive winding including a perimeter dimension defined by a spacing between the winding and an adjacent winding, the spacing being similar on each side of the spiral, and further including a shunt trace between two opposite sides of a winding.

In Example 15, the winding to which the shunt trace is coupled in the apparatus of Example 14 is an innermost winding.

In Example 16, the innermost winding in the apparatus of Example 15 comprises a secondary winding.

Example 17 is a method including forming an impedance matched transformer device on a substrate including a primary winding and a secondary winding interwound and magnetically coupled in two metal layers in a laterally coupled layout, wherein an inductance of one of the primary winding and the secondary winding is tuned for a target inductance ratio between the primary winding and the secondary. These features are part of the invention.

In Example 18, forming the transformer device in the method of Example 17 includes interwinding the primary winding and the secondary winding into a quadrilateral spiral with an innermost winding of the transformer including a perimeter dimension defined by a spacing between the innermost winding and an adjacent winding being different on at least one side of the spiral.

In Example 19, the innermost winding in the method of Example 17 including comprises a secondary winding.

In Example 20, the spacing between the innermost winding and an adjacent winding in the method of Example 19 is greater on one side of the spiral than on the other sides of the spiral and is similar on the other sides of the spiral.

In Example 21, the transformer device in the method of Example 17 is interwound into a quadrilateral spiral of the primary winding and the secondary winding with each successive winding including a perimeter dimension defined by a spacing between the winding and an adjacent winding, the spacing being similar on each side of the spiral, and forming a transformer device includes forming a shunt trace between two opposite sides of a winding.

In Example 22, the shunt trace in the method of Example 21 is formed between opposite sides of an innermost winding.

In Example 23, the innermost winding in the method of Example 22 includes a secondary winding.

The above description of illustrated implementations, including what is described in the Abstract, is not intended to be exhaustive or to limit the invention to the precise forms disclosed. While specific implementations of, and examples for, the invention are described herein for illustrative purposes, various equivalent modifications are possible within the scope, as those skilled in the relevant art will recognize.

## Claims

1. An apparatus comprising:
a device (100) comprising a primary winding (110A, 110B) and a secondary winding (120A, 120B) interwound and magnetically coupled in two metal layers, wherein an inductance of one of the primary winding and the secondary winding is tuned for a target inductance ratio between the primary winding and the secondary winding;
**characterised in that**:
the device further comprises a shunt trace (230) coupled between two opposite sides of a winding, wherein the shunt trace is disposed between opposite sides of an innermost winding, parallel to the innermost winding and is operable to reduce the secondary inductance.

2. The apparatus of claim 1, wherein the device is interwound into a quadrilateral spiral of the primary winding and the secondary winding with an innermost winding of the transformer comprising a perimeter dimension defined by a spacing (D, d) between the innermost winding and an adjacent winding being different on at least one side of the spiral.

3. The apparatus of claim 2, wherein the innermost winding comprises a secondary winding.

4. The apparatus of claim 2, wherein the spacing between the innermost winding and an adjacent winding is greater on at least one side of the spiral than on the other sides of the spiral.

5. The apparatus of claim 1, wherein the device is interwound into a quadrilateral spiral of the primary winding and the secondary winding with each successive winding comprising a perimeter dimension defined by a spacing between the winding and an adjacent winding, the spacing being similar on each side of the spiral.

6. The apparatus of claim 5, wherein the winding to which the shunt trace is coupled is an innermost winding.

7. The apparatus of claim 6, wherein the innermost winding comprises a secondary winding.

8. The apparatus of claim 1, wherein the device is a part of a package (10) that comprisesa memory chip (106).

9. A method comprising:
forming an impedance matched transformer device on a substrate comprising a primary winding and a secondary winding interwound and magnetically coupled in two metal layers in a laterally coupled layout, wherein an inductance of one of the primary winding and the secondary winding is tuned for a target inductance ratio between the primary winding and the secondary winding;
wherein forming the transformer device comprises forming a shunt trace between two opposite sides of a winding, wherein the shunt trace is disposed between opposite sides of innermost winding, parallel to the innermost winding and is operable to reduce the secondary inductance.

10. The method of claim 9, wherein forming the transformer device further comprises interwinding the primary winding and the secondary winding into a quadrilateral spiral:
(1) with an innermost winding of the transformer comprising a perimeter dimension defined by a spacing between the innermost winding and an adjacent winding being different on at least one side of the spiral, or
(2) with each successive winding comprising a perimeter dimension defined by a spacing between the winding and an adjacent winding, the spacing being similar on each side of the spiral.

## Patentansprüche

1. Vorrichtung, umfassend:
ein Gerät (100), das eine Primärwindung (110A, 110B) und eine Sekundärwindung (120A, 120B) umfasst, die miteinander verwickelt und magnetisch in zwei Metallschichten verbunden sind, wobei eine Induktivität einer Windung aus der Primärwindung und der Sekundärwindung für ein Zielinduktivitätsverhältnis zwischen der Primärwindung und der Sekundärwindung eingestellt wird;
**dadurch gekennzeichnet, dass**:
das Gerät ferner einen Widerstandsnebenschluss (230) umfasst, der zwischen zwei entgegengesetzten Seiten einer Windung liegt, wobei der Widerstandsnebenschluss zwischen entgegengesetzten Seiten einer innersten Windung angeordnet ist, parallel zur innersten Windung, und betrieben werden kann, um die sekundäre Induktivität zu reduzieren.

2. Vorrichtung nach Anspruch 1, wobei das Gerät in einer vierseitigen Spirale der Primärwindung und der Sekundärwindung mit einer innersten Windung des Transformators miteinander verbunden ist, die eine Umfangsabmessung umfasst, die durch einen Abstand (D, d) zwischen der innersten Windung und einer benachbarten Windung definiert wird, die sich auf mindestens einer Seite der Spirale unterscheiden.

3. Vorrichtung nach Anspruch 2, wobei die innerste Windung eine sekundäre Windung umfasst.

4. Vorrichtung nach Anspruch 2, wobei der Abstand zwischen der innersten Windung und einer benachbarten Windung auf mindestens einer Seite der Spirale größer als auf den anderen Seiten der Spirale ist.

5. Vorrichtung nach Anspruch 1, wobei das Gerät in eine vierseitige Spirale der Primärwindung und der Sekundärwindung mit jeder aufeinanderfolgenden Windung verwickelt ist, die eine Umfangsdimension umfasst, die durch einen Abstand zwischen der Windung und einer benachbarten Windung definiert wird, wobei der Abstand auf jeder Seite der Spirale ähnlich ist.

6. Vorrichtung nach Anspruch 5, wobei die Windung, mit der der Widerstandsnebenschluss verbunden ist, eine innerste Windung ist.

7. Vorrichtung nach Anspruch 6, wobei die innerste Windung eine sekundäre Windung umfasst.

8. Vorrichtung nach Anspruch 1, wobei das Gerät Teil einer Packung (10) ist, die einen Speicherchip (106) enthält.

9. Verfahren, umfassend:
Bilden eines impedanzangepassten Transformationsgerätes auf einem Substrat, das eine Primärwindung und eine Sekundärbindung umfasst, die miteinander verwoben sind und magnetisch in zwei Metallschichten in einem seitlich gekoppelten Layout verbunden sind, wobei eine Induktivität von einer Windung aus der Primärwindung und der Sekundärwindung für ein Ziel-Induktivitätsverhältnis zwischen der Primärwindung und der Sekundärbindung eingestellt ist;
wobei das das Bilden des Transformationsgerätes das Bilden eines Widerstandsnebenschlusses zwischen zwei entgegengesetzten Seiten einer Windung umfasst, wobei der Widerstandsnebenschluss zwischen entgegengesetzten Seiten der innersten Windung, parallel zur innersten Windung, angeordnet ist, parallel zur innen liegenden Windung, und betrieben werden kann, um die sekundäre Induktivität zu reduzieren.

10. Verfahren nach Anspruch 9, wobei das Bilden des Transformationsgerätes ferner das Verwinden der Primärwindung und der Sekundärwindung zu einer vierseitigen Spirale umfasst:
(1) wobei eine innerste Windung des Transformators eine Umfangsabmessung umfasst, die durch einen Abstand zwischen der innersten Windung und einer benachbarten Windung definiert wird, die zumindest auf einer Seite der Spirale unterschiedlich sind, oder
(2) mit jeder aufeinanderfolgenden Windung, die eine Umfangsabmessung umfasst, welche durch einen Abstand zwischen der Windung und einer benachbarten Windung definiert wird, wobei der Abstand auf jeder Seite der Spirale ähnlich ist.

## Revendications

1. Appareil comprenant :
un dispositif (100) comprenant un enroulement primaire (110A, 110B) et un enroulement secondaire (120A, 120B) enroulés l'un dans l'autre et couplés magnétiquement dans deux couches métalliques, dans lequel une inductance de l'un de l'enroulement primaire et de l'enroulement secondaire est réglée pour un rapport d'inductance cible entre l'enroulement primaire et l'enroulement secondaire ;
**caractérisé en ce que** :
le dispositif comprend en outre une trace de shunt (230) couplée entre deux côtés opposés d'un enroulement, dans lequel la trace de shunt est disposée entre des côtés opposés d'un enroulement le plus interne, parallèle à l'enroulement le plus interne et peut réduire l'inductance secondaire.

2. Appareil selon la revendication 1, dans lequel le dispositif s'enroule en spirale quadrilatérale de l'enroulement primaire et de l'enroulement secondaire avec un enroulement le plus interne du transformateur comprenant une dimension de périmètre définie par un espacement (D, d) entre l'enroulement le plus interne et un enroulement adjacent qui est différent sur au moins un côté de la spirale.

3. Appareil selon la revendication 2, dans lequel l'enroulement le plus interne comprend un enroulement secondaire.

4. Appareil selon la revendication 2, dans lequel l'espacement entre l'enroulement le plus interne et un enroulement adjacent est plus important sur au moins un côté de la spirale que sur les autres côtés de la spirale.

5. Appareil selon la revendication 1, dans lequel le dispositif s'enroule en spirale quadrilatérale de l'enroulement primaire et de l'enroulement secondaire avec chaque enroulement successif comprenant une dimension de périmètre définie par un espacement entre l'enroulement et un enroulement adjacent, l'espacement étant similaire sur chaque côté de la spirale.

6. Appareil selon la revendication 5, dans lequel l'enroulement auquel la trace de shunt est couplée est un enroulement le plus interne.

7. Appareil selon la revendication 6, dans lequel l'enroulement le plus interne comprend un enroulement secondaire.

8. Appareil selon la revendication 1, dans lequel le dispositif fait partie d'un boîtier (10) qui comprend une puce mémoire (106).

9. Procédé consistant :
à former un dispositif de transformateur à adaptation d'impédance sur un substrat comprenant un enroulement primaire et un enroulement secondaire enroulés l'un dans l'autre et couplés magnétiquement dans deux couches métalliques dans une disposition couplée latéralement, dans lequel une inductance de l'un de l'enroulement primaire et de l'enroulement secondaire est réglée pour un rapport d'inductance cible entre l'enroulement primaire et l'enroulement secondaire ;
dans lequel la formation du dispositif de transformateur consiste à former une trace de shunt entre deux côtés opposés d'un enroulement, dans lequel la trace de shunt est disposée entre des côtés opposés de l'enroulement le plus interne, parallèle à l'enroulement le plus interne et peut réduire l'inductance secondaire.

10. Procédé selon la revendication 9, dans lequel la formation du dispositif de transformateur consiste en outre à enrouler l'un dans l'autre l'enroulement primaire et l'enroulement secondaire selon une forme de spirale quadrilatérale :
(1) avec un enroulement le plus interne du transformateur comprenant une dimension de périmètre définie par un espacement entre l'enroulement le plus interne et un enroulement adjacent qui est différent sur au moins un côté de la spirale ou
(2) avec chaque enroulement successif comprenant une dimension de périmètre définie par un espacement entre l'enroulement et un enroulement adjacent, l'espacement étant similaire sur chaque côté de la spirale.
